# EUROPÄISCHE PATENTSCHRIFT

(11) **EP 2 082 445 B1**
(45) Veröffentlichungstag und Bekanntmachung des Hinweises auf die Patenterteilung: **12.12.2012**
(21) Anmeldenummer: 07821673.6
(22) Anmeldetag: 23.10.2007
(51) Int. Cl.: H01L 41/083

(54) **MONOLITHISCHER PIEZOAKTOR MIT ÜBERGANGSBEREICH UND SICHERHEITSSCHICHT SOWIE VERWENDUNG DES PIEZOAKTORS**
MONOLITHIC PIEZOACTUATOR WITH TRANSITION REGION AND SAFETY LAYER AND USE OF THE PIEZOACTUATOR
PIÉZOACTIONNEUR MONOLITHIQUE DOTÉ D'UNE ZONE DE TRANSITION ET D'UNE COUCHE DE SÉCURITÉ, ET UTILISATION DU PIÉZOACTIONNEUR

(30) Priorität: 23.10.2006 DE 102006049892
(43) Veröffentlichungstag der Anmeldung: 29.07.2009
(73) Patentinhaber: Continental Automotive GmbH, 30165 Hannover (DE); Kyocera Corporation, Kyoto 612-8501 (JP)
(72) Erfinder: INAGAKI, Masahiro, Kirishima-City, Kagoshima 899-43 (JP); KASTL, Harald Johannes, 95686 Fichtelberg (DE); SAKAMOTO, Takami, Kirishima-City, Kagoshima 899-43 (JP); SCHUH, Carsten, 85598 Baldham (DE)
(74) Vertreter: Bonn, Roman Klemens
(86) Internationale Anmeldenummer: PCT/EP2007/061309
(87) Internationale Veröffentlichungsnummer: WO 2008/049815

(56) Entgegenhaltungen:
- EP-A- 1 233 461
- DE-A1- 10 307 825
- DE-A1-102004 031 402
- DE-A1-102004 050 803

## Beschreibung

Die Erfindung betrifft einen Piezoaktor in monolithischer Vielschichtbauweise.

Bei der erstmaligen elektrischen Ansteuerung solcher Piezoaktoren bis in den Großsignalbereich (Feldstärken von mehreren kV/mm) wird der piezokeramische Werkstoff gepolt. Dabei resultiert eine irreversible Längenänderung, die so genannte remanente Dehnung. Aufgrund der remanenten Dehnung und aufgrund einer zusätzlichen Dehnung, die bei elektrischer Ansteuerung der Elektrodenschichten im Betrieb des Piezoaktors auftritt, entstehen im Gesamtstapel Zugspannungen. Diese Zugspannungen führen dazu, dass im Verlauf der Polung oder im Betrieb des Piezoaktors beispielsweise entlang einer Grenzfläche zwischen einer Piezokeramikschicht und einer Elektrodenschicht Risse (Polungsrisse) entstehen. Solche Risse treten insbesondere im Übergangsbereich zwischen aktivem Teilstapel und Abschlussbereich auf. Besonders schädlich sind dabei sich verzweigende oder sich in Längsrichtung des Gesamtstapels ausbreitende Risse. Solche Risse führen unweigerlich zu vorzeitigem Ausfall des Piezoaktors.

Aus der europäischen Offenlegungsschrift EP 1 233 461 A2 geht ein piezokeramischer Vielschichtaktor hervor, der einen Kopfbereich und einen Fußbereich aus inaktiven elektrodenfreien Lagen von Piezokeramik aufweist. Aufgrund unterschiedlichen Dehnungsverhaltens des aktiven und des passiven Bereiches während des Betriebes tritt Rissbildung auf. Zur Vermeidung der Rissbildung wird an dem aktiven Bereich jeweils zum inaktiven Kopfbereich bzw. zum inaktiven Fußbereich hin, ein Übergangsbereich hin angeschlossen. Das Schwingungs- und Dehnungsverhalten dieses Übergangsbereiches liegt zwischen dem Fügungs- und Dehnungsverhalten des aktiven Bereichs und dem eines inaktiven Bereichs. Die Gestaltung des Übergangsbereichs kann durch differenzierte Abstände zwischen Innenelektroden zu den Enden des Aktors realisiert werden.

Die deutsche Offenlegungsschrift DE 10 2004 050 803 Al offenbart einen Piezoaktor mit Mehrschichtaufbau, in welchem im Bereich des Schichtaufbaus in vorgegebenen Abständen Keramikschichten als Entlastungsschichten angeordnet sind. Diese weisen eine andere Stoffzusammensetzung oder einen anderen Aufbau auf, sodass eine höhere Neigung zur Rissbildung vorliegt.

Aus dem Stand der Technik ergibt sich keine weitere Möglichkeit, die Zuverlässigkeit eines Piezoaktors zu steigern.

Aufgabe der Erfindung ist es, einen Piezoaktor anzugeben, bei dem eine erhöhte Zuverlässigkeit durch verringerte Rissbildung und deren Wachstum erzielt werden kann.

Zur Lösung der Aufgabe wird ein Piezoaktor in monolithischer Vielschichtbauweise mit einem Gesamtstapel angegeben, aufweisend mindestens einen piezoelektrisch aktiven Teil-Stapel, wobei der Teil-Stapel übereinander angeordnete Piezokeramikschichten und zwischen den Piezokeramikschichten angeordnete Elektrodenschichten aufweist, mindestens einen über dem piezoelektrisch aktiven Teil-Stapel angeordneten piezoelektrisch inaktiven Abschlussbereich und mindestens einen zwischen dem piezoelektrisch aktiven Teil-Stapel und dem Abschlussbereich angeordneten Übergangsbereich, wobei der Übergangsbereich übereinander angeordnete Übergangsbereichs-Piezokeramikschichten und zwischen den Übergangsbereichs-Piezokeramikschichten angeordnete Übergangsbereichs-Elektrodenschichten aufweist und die Übergangsbereichs-Piezokeramikschichten und die Übergangsbereichs-Elektrodenschichten derart ausgestaltet und aneinander angeordnet sind, dass in Stapelrichtung des Übergangsbereichs von Übergangsbereichs-Piezokeramikschicht zu Übergangsbereichs-Piezokeramikschicht sukzessive durch elektrische Ansteuerung der Übergangsbereichs-Elektrodenschichten in die Übergangsbereichs-Piezokeramikschichten einkoppelbare elektrische Felder geändert sind, und der piezoelektrisch aktive Teil-Stapel zum Übergangsbereich hin eine Sicherheitsschicht aufweist, bei der bei mechanischer Überlastung bevorzugt ein Riss gebildet wird.
Es erstreckt sich die Stapelrichtung des Übergangsbereichs vom elektrisch aktiven Teil-Stapel in Richtung des Abschlussbereichs. Dabei nimmt eine Schichtdicke der Übergangsbereichs-Elektrodenschichten von Übergangsbereichs-Elektrodenschicht zu Übergangsbereichs-Elektrodenschicht sukzessive zu.

Der Abschlussbereich kann ein Kopf- oder Fußbereich des Gesamtstapels sein. Der Abschlussbereich kann aus einer Schicht oder aus mehreren Schichten bestehen. Im letzteren Fall wird von einem Deckpaket gesprochen. Als Material des Abschlussbereichs kommen keramische oder metallische Materialien in Frage.

Ein piezokeramischer Werkstoff der Piezokeramikschichten und ein piezokeramischer Werkstoff der Übergangsbereichs-Piezokeramikschichten können gleich sein. Es können aber auch unterschiedliche Werkstoffe verwendet werden.

Die grundlegende Idee der Erfindung besteht darin, einen Übergangsbereich mit Gradierung bezüglich Auslenkung der Piezokeramik bereitzustellen. Die Gradierung führt dazu, dass sich die Auslenkung der Piezokeramik bei elektrischer Ansteuerung der Übergangsbereichs-Elektrodenschichten sukzessive von Übergangsbereichs-Piezokeramikschicht zu Übergangsbereichs-Piezokeramikschicht ändert. Die Auslenkung wird vom aktiven Teil-Stapel zum inaktiven Abschlussbereich hin reduziert. Es findet eine Anpassung der Auslenkung statt. Dadurch werden die internen mechanischen Spannungen aufgrund der unterschiedlichen Auslenkungen reduziert. Gleichzeitig ist in der Nähe eine Sicherheitsschicht angeordnet. Diese Sicherheitsschicht fungiert als Sollbruchstelle. Die Sicherheitsschicht bildet das schwächste Glied im monolithischen Gesamtstapel. Ein Riss wird bei mechanischer Überlastung (intern oder von außen induziert) vornehmlich in oder an der Sicherheitsschicht gebildet. Es hat sich gezeigt, dass die Kombination Gradierung im Übergangsbereich und Sicherheitsschicht im piezoelektrisch aktiven Teil-Stapel zu einer deutlich erhöhten Zuverlässigkeit des Piezoaktors führt.

Die Zunahme der Schichtdicken kann beliebig gewählt werden. Vorteilhaft nehmen die Schichtdicken der Übergangsbereichs-Piezokeramikschichten ausgehend von einer Schichtdicken-Einheit mit folgenden Faktoren zu: 1,2; 1,5; 2,0; 2,8; 3,8. Eine alternative Reihe ist beispielsweise durch folgende Faktoren definiert: 1,1; 1,3; 1,6; 2,0; 2,5; 3,1; beispielsweise wie folgt: Die Schichtdicken-Einheit beträgt beispielsweise 80 µm.

Die Übergangs-Piezokeramikschichten können aus jeweils einer Schicht aufgebaut sein. Sie sind einschichtig. Vorteilhaft ist es aber, wenn die Übergangsbereichs-Piezokeramikschichten mehrschichtig sind. Zumindest eine der Übergangsbereichs-Piezokeramikschichten weist dazu übereinander angeordnete Einzel-Piezokeramikschichten auf. Die mehrschichtige Übergangsbereichs-Piezokeramikschicht wird bei der Herstellung aus mehreren piezokeramischen Grünfolien aufgebaut.

Insbesondere entspricht die Schichtdicken-Einheit der Ubergangsbereichs-Piezokeramikschichten einer Schichtdicke einer Piezokeramikschicht des piezoelektrisch aktiven Teil-Stapels. Dies bedeutet beispielsweise, dass die unmittelbar an den piezoelektrisch aktiven Teilstapel angrenzende Übergangsbereichs-Piezokeramikschicht die Schichtdicke der benachbarten Piezokeramikschicht des piezoelektrisch aktiven Teil-Stapels aufweist.

Als besonders vorteilhaft hat sich herausgestellt, dafür zu sorgen, dass zwischen der Sicherheitsschicht des piezoelektrisch aktiven Teil-Stapels und dem Übergangsbereich maximal zehn Piezokeramikschichten und insbesondere maximal 5 Piezokeramikschichten angeordnet sind. Es ist dafür gesorgt, dass die Sicherheitsschicht in der Nähe des Übergangsbereichs angeordnet ist.

Die Sicherheitsschicht kann von einer Piezokeramikschicht des aktiven Teilstapels gebildet sein. Insbesondere ist die Sicherheitsschicht von einer der Elektrodenschichten des piezoelektrisch aktiven Teil-Stapels und/oder von einer Grenzfläche zwischen einer der Elektrodenschichten und einer benachbarten Piezokeramikschicht des piezoelektrisch aktiven Teil-Stapels gebildet.

Gemäß einer besonderen Ausgestaltung weist der aktive Teilstapel und/oder der Abschlussbereich eine aus dem Bereich von einschließlich 1 mm bis einschließlich 10 mm und insbesondere aus dem Bereich von einschließlich 3 mm bis einschließlich 5 mm ausgewählte Teilstapelhöhe aufweist. Beispielsweise beträgt die Teilstapelhöhe 2 mm. Es hat sich gezeigt, dass mit diesen Teilstapelhöhen Spannungsspitzen sehr gut abgebaut werden. Gemäß einer besonderen Ausgestaltung weist der Übergangsbereichs-Teilstapel eine aus dem Bereich von einschließlich 0,2 bis einschließlich 5,0 mm und insbesondere von einschließlich 0,5 bis einschließlich 2,0 mm ausgewählte Übergangsstapelhöhe auf. Mit den Teilstapeln sind sehr hohe Gesamtstapel zugänglich. In einer besonderen Ausgestaltung weist der Gesamtstapel eine Gesamtstapelhöhe auf, die aus dem Bereich von einschließlich 10 mm bis einschließlich 200 mm ausgewählt ist. Höhere Gesamtstapelhöhen sind ebenfalls zugänglich.

Weitere Maßnahme zur Reduzierung der bei der elektrischen Ansteuerung im Gesamtstapel auftretenden mechanischen Spannungen können zusätzlich vorgenommen werden. Diese Maßnahmen betriffen beispielsweise eine Integration von elektrisch inaktiven Elektrodenschichten im Abschlussbereich. Die elektrisch inaktiven Elektrodenschichten werden während der Polung und während des Betriebs des Piezoaktors elektrisch nicht angesteuert.

Dieser neue, zuverlässige Piezoaktor wird bevorzugt zur Ansteuerung eines Ventils und insbesondere eines Einspritzventils einer Brennkraftmaschine verwendet. Die Brennkraftmaschine ist beispielsweise ein Motor eines Kraftfahrzeugs.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.

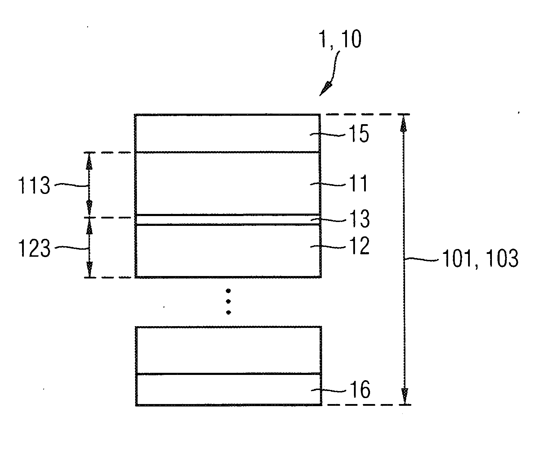

Die Figur zeigt einen Piezoaktor in monolithischer Vielschichtbauweise von der Seite.

Der Piezoaktor 1 ist ein Piezoaktor mit einem Gesamtstapel 10 in monolithischer Vielschichtbauweise. Der Piezoaktor 1 weist einen piezoelektrisch aktiven Teilstapel 12 mit alternierend übereinander angeordneten Piezokeramikschichten mit Bleizirkonattitanat (PZT) als piezokeramischem Werkstoff und Elektrodenschichten aus einer Silber-Palladium-Legierung auf.

Über dem piezoelektrisch aktiven Teilstapel 12 ist ein piezoelektrisch inaktiver Abschlussbereich 15 in Form eines keramischen Deckpakets aus keramischen Schichten angeordnet.

Zwischen dem piezoelektrisch aktiven Teilstapel 12 und dem Deckpaket 15 ist ein Ubergangsbereich 11 in Form eines Übergangsbereichs-Stapels angeordnet. Der Übergangsbereichs-Stapel 11 weist alternierend übereinander angeordnete Übergangsbereichs-Piezokeramikschichten und Übergangsbereichs-Elektrodenschichten auf. Der piezokeramische Werkstoff der Übergangsbereichs-Piezokeramikschichten und der piezokeramische Werkstoff der Piezokeramikschichten des piezoelektrisch aktiven Teilstapels sind gleich. In einer alternativen Ausgestaltung sind die piezokeramischen Werkstoffe unterschiedlich. Das Elektrodenmaterial der Übergangsbereichs-Elektrodenschichten entspricht dem der Elektrodenschichten des piezoelektrisch aktiven Teil-Stapels. Alternativ werden unterschiedliche Elektrodenmaterialien verwendet.

Der piezoelektrisch aktive Teilstapel, der Übergangsbereichs-Stapel und der Abschlussbereich bilden zusammen einen monolithischen Gesamtstapel 10. An Seitenflächen des Gesamtstapels im Bereich des aktiven Teilstapels und im Bereich des Übergangsbereichs-Stapels sind nicht dargestellte Außenmetallisierungen zur elektrischen Kontaktierung der jeweiligen Elektrodenschichten angebracht.

Die Gesamthöhe 103 des Gesamtstapels 10 in Stapelrichtung 101 beträgt 30 mm. Die Teilstapelhöhe 123 piezoelektrisch aktiven Teilstapels 12 beträgt etwa 10 mm. Die Übergangsbereichs-Teilstapelhöhe 113 des Übergangsbereichs-Stapels 11 beträgt etwa 2 mm.

Innerhalb des Übergangsbereichs-Teilstapels nehmen ein Stapelrichtung vom aktiven Teil-Stapel zum Abschlussbereich hin die Schichtdicken der Übergangsbereichs-Piezokeramikschichten zu.

Zusätzlich ist innerhalb des aktiven Teilstapels 12 in der Nähe des Übergangsbereichs 11 eine Sicherheitsschicht 13 angeordnet. Die Sicherheitsschicht 13 ist von einer Elektrodenschicht gebildet.

Weitere Ausführungsbeispiele ergeben sich dadurch, dass nicht nur bzw. alternativ zur dargestellten Anordnung ein Abschlussbereich 16 mit zugehörigem Übergangsbereich im Fußbereich des Gesamtstapels vorgesehen ist.

Dieser neue Piezoaktor 1 wird zur Ansteuerung eines Einspritzventils eines Motors eines Kraftfahrzeugs verwendet.

## Patentansprüche

1. Piezoaktor (1) in monolithischer Vielschichtbauweise mit einem Gesamtstapel (10), aufweisend:
- mindestens einen piezoelektrisch aktiven Teil-Stapel (12), wobei der Teil-Stapel übereinander angeordnete Piezokeramikschichten und zwischen den Piezokeramikschichten angeordnete Elektrodenschichten aufweist,
- mindestens einen über dem piezoelektrisch aktiven Teil-Stapel (12), angeordneten piezoelektrisch inaktiven Abschlussbereich (15) und
- mindestens einen zwischen dem piezoelektrisch aktiven Teil-Stapel (12), und dem Abschlussbereich angeordneten Übergangsbereich (11),
wobei
- der Übergangsbereich (11) übereinander angeordnete Übergangsbereichs-Piezokeramikschichten und zwischen den Übergangsbereichs-Piezokeramikschichten angeordnete Übergangsbereichs-Elektrodenschichten aufweist und
- die Übergangsbereichs-Piezokeramikschichten und die Übergangsbereichs-Elektrodenschichten derart ausgestaltet und aneinander angeordnet sind, dass in Stapelrichtung des Übergangsbereichs (11) von Übergangsbereichs-Piezokeramikschicht zu Übergangsbereichs-Piezokeramikschicht sukzessive durch elektrische Ansteuerung der Übergangsbereichs-Elektrodenschichten in die Übergangsbereichs-Piezokeramikschichten einkoppelbare elektrische Felder geändert sind,
- der piezoelektrisch aktive Teil-Stapel (12) zum Übergangsbereich (11) hin eine Sicherheitsschicht (13) aufweist, bei der bei mechanischer Überlastung bevorzugt ein Riss gebildet wird, und
- sich die Stapelrichtung des Übergangsbereichs vom elektrisch aktiven Teil-Stapel (12) in Richtung des Abschlussbereichs erstreckt und eine Schichtdicke der Übergangsbereichs-Elektrodenschichten von Übergangsbereichs-Elektrodenschicht zu Übergangsbereichs-Elektrodenschicht sukzessive zunimmt.

2. Piezoaktor nach Anspruch 1, wobei die Schichtdicken der Übergangsbereichs-Piezokeramikschichten ausgehend von einer Schichtdicke einer zum piezoelektrischen aktiven Teil-Stapel (12) benachbarten Übergangsbereichs-Piezokeramikschicht mit folgenden Faktoren zunehmen: 1,2; 1,5; 2,0; 2,8; 3,8.

3. Piezoaktor nach Anspruch 1 oder 2, wobei zumindest eine der Übergangsbereichs-Piezokeramikschichten übereinander angeordnete Einzel-Piezokeramikschichten aufweist.

4. Piezoaktor nach einem der Ansprüche 1 bis 3, wobei die Schichtdicke der an den piezoelektrisch aktiven Teilstapel (12) unmittelbar angrenzenden Übergangsbereichs-Piezokeramikschicht einer Schichtdicke einer Piezokeramikschicht des piezoelektrisch aktiven Teil-Stapels (12) entspricht.

5. Piezoaktor nach einem der Ansprüche 1 bis 4, wobei zwischen der Sicherheitsschicht (13) des piezoelektrisch aktiven Teil-Stapels (12) und dem Übergangsbereich (11) maximal zehn Piezokeramikschichten und insbesondere maximal 5 Piezokeramikschichten angeordnet sind.

6. Piezoaktor nach einem der Ansprüche 1 bis 5, wobei die Sicherheitsschicht von einer der Elektrodenschichten des piezoelektrisch aktiven Teil-Stapels (12) und/oder von einer Grenzfläche zwischen einer der Elektrodenschichten und einer benachbarten Piezokeramikschicht des piezoelektrisch aktiven Teil-Stapels (12) gebildet ist.

7. Piezoaktor nach einem der Ansprüche 1 bis 6, wobei der piezoelektrisch aktive Teil-Stapel (12) und/oder der Abschlussbereich eine aus dem Bereich von einschließlich 1 mm bis einschließlich 10 mm und insbesondere eine aus dem Bereich von einschließlich 3 mm bis einschließlich 5 mm ausgewählte Teilstapelhöhe (123) aufweist.

8. Piezoaktor nach einem der Ansprüche 1 bis 7, wobei der der Übergangsbereich (11) einen Übergangsbereich-Teilstapel mit einer aus dem Bereich von einschließlich 0,2 bis einschließlich 5,0 mm und insbesondere von einschließlich 0,5 bis einschließlich 2,0 mm ausgewählten Übergangsstapelhöhe aufweist.

9. Piezoaktor nach einem der Ansprüche 1 bis 8, wobei der Gesamtstapel eine Gesamtstapelhöhe (103) aufweist, die aus dem Bereich von einschließlich 10 mm bis einschließlich 200 mm ausgewählt ist.

10. Verwendung eines Piezoaktors nach einem der Ansprüche 1 bis 9 zur Ansteuerung eines Ventils und insbesondere eines Einspritzventils einer Brennkraftmaschine.

## Claims

1. Piezoactuator (1) of monolithic multilayer structure with an overall stack (10), having:
- at least one piezoelectrically active partial stack (12), the partial stack having piezoceramic layers arranged one above another and electrode layers arranged between the piezoceramic layers,
- at least one piezoelectrically inactive terminating region (15) arranged above the piezoelectrically active partial stack (12), and
- at least one transition region (11) arranged between the piezoelectrically active partial stack (12) and the terminating region,
in which
- the transition region (11) has transition region piezoceramic layers arranged one above another and transition region electrode layers arranged between the transition region piezoceramic layers, and
- the transition region piezoceramic layers and the transition region electrode layers are configured and arranged on one another in such a way that there is a change in the electric fields which can be coupled into the transition region piezoceramic layers by electrical driving of the transition region electrode layers successively in the stack direction of the transition region (11) from transition region piezoceramic layer to transition region piezoceramic layer,
- the piezoelectrically active partial stack (12) has a safety layer (13) towards the transition region (11) in the case of which a crack is preferably formed given mechanical overloading, and
- the stack direction of the transition region extends from the electrically active partial stack (12) in the direction of the terminating region, and a layer thickness of the transition region electrode layers increases successively from transition region electrode layer to transition region electrode layer.

2. Piezoactuator according to Claim 1, in which, starting from a layer thickness of a transition region piezoceramic layer adjacent to the piezoelectrically active partial stack (12), the layer thicknesses of the transition region piezoceramic layers increase by the following factors: 1.2; 1.5; 2.0; 2.8; 3.8.

3. Piezoactuator according to Claim 1 or 2, in which at least one of the transition region piezoceramic layers has individual piezoceramic layers arranged one above another.

4. Piezoactuator according to one of Claims 1 to 3, in which the layer thickness of the transition region piezoceramic layer directly adjacent to the piezoelectrically active partial stack (12) corresponds to a layer thickness of a piezoceramic layer of the piezoelectrically active partial stack (12).

5. Piezoactuator according to one of Claims 1 to 4, in which a maximum of ten piezoceramic layers and, in particular, a maximum of 5 piezoceramic layers are arranged between the safety layer (13) of the piezoelectrically active partial stack (12) and the transition region (11).

6. Piezoactuator according to one of Claims 1 to 5, in which the safety layer is formed by one of the electrode layers of the piezoelectrically active partial stack (12), and/or by an interface between one of the electrode layers and an adjacent piezoceramic layer of the piezoelectrically active partial stack (12).

7. Piezoactuator according to one of Claims 1 to 6, in which the piezoelectrically active partial stack (12) and/or the terminating region has a partial stack height (123) selected from the range of from 1 mm to 10 mm inclusive and, in particular, from the range of from 3 mm to 5 mm inclusive.

8. Piezoactuator according to one of Claims 1 to 7, in which the transition region (11) has a transition region partial stack with a transition stack height selected from the range of from 0.2 to 5.0 mm inclusive and, in particular, of from 0.5 to 2.0 mm inclusive.

9. Piezoactuator according to one of Claims 1 to 8, in which the overall stack has an overall stack height (103) which is selected from the range of from 10 mm to 200 mm inclusive.

10. Use of a piezoactuator according to one of Claims 1 to 9 to drive a valve and, in particular, an injection valve of an internal combustion engine.

## Revendications

1. Actionneur piézoélectrique (1) de type monolithique multicouche avec un empilement global (10), comprenant :
- au moins un empilement partiel (12) actif sur le plan piézoélectrique, ledit empilement partiel comportant des couches piézocéramiques agencées les unes au-dessus des autres et des couches électrodes agencées entre les couches piézocéramiques,
- au moins une zone de recouvrement (15) inactive sur le plan piézoélectrique, agencée au-dessus de l'empilement partiel (12) actif sur le plan piézoélectrique, et
- au moins une zone de transition (11), agencée entre l'empilement partiel (12) actif sur le plan piézoélectrique et la zone de recouvrement,
dans lequel
- la zone de transition (11) comporte des couches piézocéramiques de transition disposées les unes au-dessus des autres et des couches électrodes de transition disposées entre les couches piézocéramiques de transition, et
- les couches piézocéramiques de transition et les couches électrodes de transition sont configurées et agencées les unes par rapport aux autres de telle sorte que dans le sens d'empilement de la zone de transition (11) d'une couche piézocéramique de transition vers l'autre, des champs électriques injectables dans les couches piézocéramiques de transition sont modifiés successivement par la commande électrique des couches électrodes de transition,
- l'empilement partiel (12) actif sur le plan piézoélectrique comporte dans la direction de la zone de transition (11) une couche de sécurité (13), dans laquelle une fissure se forme de préférence sous l'effet d'un effort mécanique excessif, et
- la direction d'empilement de la zone de transition s'étend depuis l'empilement partiel (12) actif sur le plan piézoélectrique vers la zone de recouvrement et l'épaisseur des couches électrodes de transition augmente successivement d'une couche électrode de transition vers l'autre couche électrode de transition.

2. Actionneur piézoélectrique selon la revendication 1, dans lequel, à partir d'une épaisseur d'une couche piézocéramique de transition, voisine de l'empilement partiel (12) actif sur le plan piézoélectrique, les épaisseurs des couches piézocéramiques de transition augmentent selon les facteurs suivants : 1,2 ; 1,5 ; 2,0 ; 2,8 ; 3,8.

3. Actionneur piézoélectrique selon la revendication 1 ou 2, dans lequel au moins une des couches piézocéramiques de transition comporte des couches piézocéramiques individuelles agencées les unes au-dessus des autres.

4. Actionneur piézoélectrique selon l'une quelconque des revendications 1 à 3, dans lequel l'épaisseur de la couche piézocéramique de transition, directement adjacente à l'empilement partiel (12) actif sur le plan piézoélectrique, correspond à une épaisseur d'une couche piézocéramique de l'empilement partiel (12) actif sur le plan piézoélectrique.

5. Actionneur piézoélectrique selon l'une quelconque des revendications 1 à 4, dans lequel au maximum dix couches piézocéramiques et, en particulier, au maximum cinq couches piézocéramiques, sont agencées entre la couche de sécurité (13) de l'empilement partiel (12) actif sur le plan piézoélectrique et la zone de transition (11).

6. Actionneur piézoélectrique selon l'une quelconque des revendications 1 à 5, dans lequel la couche de sécurité est formée par une des couches électrodes de l'empilement partiel (12) actif sur le plan piézoélectrique et/ou par une interface entre une des couches électrodes et une couche piézocéramique voisine de l'empilement partiel (12) actif sur le plan piézoélectrique.

7. Actionneur piézoélectrique selon l'une quelconque des revendications 1 à 6, dans lequel l'empilement partiel (12) actif sur le plan piézoélectrique et/ou la zone de recouvrement ont une hauteur d'empilement partiel (123) choisie dans la plage de 1 mm inclus jusqu'à 10 mm inclus et en particulier dans la plage de 3 mm inclus jusqu'à 5 mm inclus.

8. Actionneur piézoélectrique selon l'une quelconque des revendications 1 à 7, dans lequel la zone de transition (11) comporte un empilement partiel de transition avec une hauteur d'empilement de transition choisie dans la plage de 0,2 mm inclus jusqu'à 5,0 mm inclus et, en particulier, une plage de 0,5 mm inclus jusqu'à 2,0 mm inclus.

9. Actionneur piézoélectrique selon l'une quelconque des revendications 1 à 8, dans lequel l'empilement global a une hauteur (103) qui est choisie dans la plage de 10 mm inclus jusqu'à 200 mm inclus.

10. Utilisation d'un actionneur piézoélectrique selon l'une quelconque des revendications 1 à 9, pour commander une soupape et en particulier une soupape d'injection d'un moteur à combustion interne.
